# EUROPÄISCHE PATENTSCHRIFT

(11) **EP 0 553 464 B1**
(45) Veröffentlichungstag und Bekanntmachung des Hinweises auf die Patenterteilung: **06.09.1995**
(21) Anmeldenummer: 92121409.4
(22) Anmeldetag: 16.12.1992
(51) Int. Cl.: H01L 31/0352, H01L 27/142, H01L 31/18

(54) **Verfahren zur Herstellung einer Solarzelle aus einer Substratscheibe**
Fabrication process of a solar cell from a wafer substrate
Procédé de fabrication d'une cellule solaire à partir d'un substrat

(30) Priorität: 29.01.1992 DE 4202455
(43) Veröffentlichungstag der Anmeldung: 04.08.1993
(73) Patentinhaber: SIEMENS AKTIENGESELLSCHAFT, 80333 München (DE)
(72) Erfinder: Lehmann, Volker, Dr., W-8000 München 21 (DE); Stengl, Reinhard, Dr., W-8901 Stadtbergen (DE); Wendt, Hermann, Dr., W-8011 Neukeferloh (DE); Hönlein, Wolfgang, Dr., W-8025 Unterhaching (DE); Willer, Josef, Dr., W-8012 Riemerling (DE)

(56) Entgegenhaltungen:
- EP-A- 0 296 348
- DE-A- 3 225 118
- US-A- 3 969 746
- US-A- 4 409 423
- PROCEEDINGS OF IEEE MICRO ELECTRO MECHANICAL SYSTEMS, 30. Januar 1991, NARA, JAPAN, Seiten 221-226, BRANEJBERG et al.: 'DOPANT SELECTIVE HF ANODIC ETCHING OF SILICON'

## Beschreibung

Zur Herstellung Von Solarzellen werden unter anderem Substratscheiben aus einkristallinem Silizium verwendet. Die daraus hergestellten einkristallinen Solarzellen sind anderen nicht kristalline bezüglich Wirkungsgrad und Langzeitstabilität überlegen. Nachteilig ist jedoch der hohe Preis einkristalliner Solarzellen. Dieser hängt mit der Verwendung von einkristallinem Silizium Zusammen.

Ein theoretischer Wert für eine ideale Dicke einer Solarzelle aus einkristallinem Silizium liegt bei etwa 0,06 mm. Substratscheiben, aus denen Solarzellen hergestellt werden, können minimal auf eine Dicke von 0,3 mm gesägt werden. Daraus hergestellte Solarzellen sind dann um ein Vielfaches dicker, als es für das Funktionieren der Solarzelle erforderlich wäre. Darüberhinaus trägt das überschüssige einkristalline Siliziummaterial zu einer Vergrößerung des Widerstands bei und verschlechtert so die Eigenschaften der Solarzelle (s. z. B. Phys. Bl. Bd. 47 (1991) S. 1075 - 1076).

Der Erfindung liegt das Problem zugrunde, ein Verfahren zur Herstellung einer Solarzelle aus einer Substratscheibe anzugeben, bei dem das Material der Substratscheibe besser ausgenutzt wird.

Dieses Problem wird erfindungsgemäß gelöst durch ein Verfahren nach Anspruch 1.

Weitere Ausgestaltungen der Erfindung gehen aus den übrigen Ansprüchen hervor.

Da die Substratscheibe bei der elektrochemischen Ätzung als Anode geschaltet ist, bewegen sich Minoritätsladungsträger in dem n-dotierten Silizium zu der mit dem Elektrolyten in Kontakt stehenden Oberfläche. An dieser Oberfläche bildet sich eine Raumladungszone aus. Da die Feldstärke im Bereich von Vertiefungen in der Oberfläche größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsladungsträger bewegen sich wegen der vergrößerten Feldstärke dorthin und desto stärker ist der Ätzangriff an dieser Stelle. Die Löcher wachsen in der kristallographischen 〈100〉-Richtung. Es ist vorteilhaft, eine Substratscheibe mit 〈100〉-Orientierung zu verwenden, da dann die Löcher senkrecht zur ersten Oberfläche wachsen. Das führt wiederum zu einer gleichmäßigen Strukturierung der Substratscheibe.

Die elektrochemische Ätzung von n-dotiertem Silizium zur Herstellung von Löchern oder Gräben ist z. B. aus EP 0 296 348 Al bekannt, in der Gräben insbesondere für DRAM-Zellen auf diese Weise hergestellt werden. Die Möglichkeit, dieses Ätzverfahrens zum Ablösen freitragender Schichten anzuwenden, wird dort allerdings nicht in Betracht gezogen.

Der Ätzangriff ist abhängig von der Stromdichte in der Substratscheibe und von der Konzentration in dem Elektrolyten. Durch Erhöhung der Stromdichte im Elektrolyten oder durch Verminderung der Konzentration im Elektrolyten wird der Ätzangriff vergrößert. Diese Tatsache wird in dem erfindungsgemäßen Verfahren ausgenutzt, um bei Erreichen einer Tiefe der Löcher, die im wesentlichen der Dicke der freitragenden Schicht entspricht, den Ätzabtrag so zu vergrößern, daß der Querschnitt der Löcher wächst. Da, wie oben ausgeführt, der Ätzangriff nur im unteren Bereich der Löcher stattfindet, bleibt der Querschnitt der Löcher im oberen Bereich, d. h. in der Nähe der ersten Oberfläche, dabei unverändert. Im unteren Bereich jedoch wachsen die Löcher sowohl in die Breite als auch in die Tiefe. Die elektrochemische Ätzung wird solange fortgesetzt, bis benachbarte Löcher zusammenwachsen und dadurch die freitragende Schicht abgelöst wird.

Die freitragende Schicht besteht wie die Substratscheibe aus n-dotiertem, einkristallinem Silizium. Die freitragende Schicht wird nun zur Herstellung der Solarzelle verwendet.

Die Dicke der freitragenden Schicht ist über die Tiefe der Löcher einstellbar. Mit dem erfindungsgemäßen Verfahren kann die freitragende Schicht in einer Dicke von mindestens 10 µm auf jeden beliebigen Wert der Dicke eingestellt werden. Die freitragende Schicht kann gut in einer Dicke von ungefähr 60 µm hergestellt werden. Die Dicke der Solarzelle kann daher auf den theoretischen Wert für die ideale Dicke eingestellt werden. Nach dem erfindungsgemäßen Verfahren hergestellte Solarzellen können daher mit einem verminderten Bahnwiderstand realisiert werden. Der Bahnwiderstand einer Solarzelle ist kristisch für deren Wirkungsgrad. Je geringer der Bahnwiderstand der Solarzelle ist, desto größer ist deren Wirkungsgrad. Nach dem erfindungsgemäßen Verfahren können daher Solarzellen mit stark verbessertem Wirkungsgrad hergestellt werden.

Darüberhinaus sind Solarzellen geringer Dicke, wie sie in dem erfindungsgemäßen Verfahren hergestellt werden können, weniger empfindlich auf Schädigung durch Alphastrahlung. Strahlungsschäden durch Alphastrahlung stellen beim Einsatz von Solarzellen in der Stromversorgung von Satelliten ein Problem dar.

Ferner ist die Oberfläche der freitragenden Schicht durch den Ätzprozeß rauh und ergibt damit eine optische Reflektionsminimierung ohne zusätzliche Prozeßschritte.

Die Stromdichte in der Substratscheibe ist durch Beleuchtung einer der ersten Oberfläche gegenüberliegenden, zweiten Oberfläche der Substratscheibe besonders einfach zu beeinflussen.

In diesem Fall wird das Ablösen der freitragenden Schicht durch Vergrößerung der Beleuchtung erzielt.

Es liegt im Rahmen der Erfindung, vor der Bildung der Löcher, die erste Oberfläche der Substratscheibe mit einer Oberflächentopologie zu versehen. Auf diese Weise wird die erste Oberfläche gezielt mit Vertiefungen versehen, an denen der Ätzangriff beim elektrochemischen Ätzen beginnt. Wird die erste Oberfläche mit einer Oberflächentopologie aus regelmäßig angeordneten Vertiefungen versehen, zeigt die abgelöste, freitragende Schicht eine im wesentlichen konstante Dicke. In diesem Fall ist nämlich der Abstand der Löcher im wesentlichen gleich, so daß die Materialmenge zwischen benachbarten Löchern, die durch Vergrößerung des Ätzangriffs zum Ablösen der freitragenden Schicht abgeätzt werden muß, im wesentlichen gleich ist. Dann wachsen im wesentlichen alle Löcher gleichzeitig zusammen.

Für Anwendungen, bei denen es auf eine konstante Dicke der freitragenden Schicht nicht ankommt, kann die Erzeugung der Oberflächentopologie unterbleiben. Das führt in diesem Fall zu einer Prozeßvereinfachung.

Die Oberflächentopologie wird dabei z. B. nach Herstellung einer Fotolackmaske auf der ersten Oberfläche und anschließender alkalischer Ätzung der ersten Oberfläche erzeugt. Zur Herstellung der Fotolackmaske wird dabei konventionelle optische Fotolithographie verwendet.

Es liegt im Rahmen der Erfindung, die Oberflächentopologie durch lichtinduzierte, elektrochemische Ätzung in demselben Elektrolyten, in dem anschließend die Löcher geätzt werden, herzustellen. Dabei wird auf der ersten Oberfläche unter Verwendung einer Lichtquelle mit einer Wellenlänge kleiner als 1100 nm ein Beleuchtungsmuster erzeugt. Die Stromdichte in der Substratscheibe wird so eingestellt, daß nur an belichteten Stellen des Beleuchtungsmusters lokal ein anodischer Minoritätsträgerstrom über die Substratscheibe fließt der einen Ätzabtrag der ersten Oberfläche bewirkt. Dieses Vorgehen hat den Vorteil, daß zur Erzeugung der Oberflächentopologie keine gesonderte Ätztechnik angewendet werden muß.

Es liegt im Rahmen der Erfindung, nach dem Ablösen der freitragenden Schicht mindestens eine weitere freitragende Schicht von der verbleibenden Substratscheibe durch elektrochemisches Ätzen abzulösen. Das Verfahren kann zum Ablösen weiterer freitragender Schichten so oft wiederholt werden, bis die mechanische Stabilität der verbleibenden Substratscheibe nicht mehr ausreichend ist.

Aus einer Substratscheibe, die durch Sägen in einer Dicke von 500 µm hergestellt ist, wie sie in der herkömmlichen Solarzellenherstellung verwendet wird, können z. B. zehn abgelöste freitragende Schichten mit einer Dicke von je 30 µm hergestellt werden. Jede der freitragenden Schichten ist Ausgangsmaterial für die weitere Solarzellenherstellung. Da in dem erfindungsgemäßen Verfahren die freitragende Schicht Ausgangsmaterial für die Solarzellenherstellung ist, während in herkömmlichen Verfahren die gesägte Substratscheibe Ausgangsmaterial für die Solarzellenherstellung ist, beträgt die Ausbeute pro gesägter Substratscheibe im erfindungsgemäßen Verfahren bei der Herstellung der Solarzellen ein Vielfaches, im genannten Beispiel Zehnfaches, von der im herkömmlichen Verfahren.

Da das Material der gesägten Substratscheibe in dem erfindungsgemäßen Verfahren viel besser ausgenutzt wird als in den herkömmlichen Verfahren, sinkt der Materialpreis für die in jeder einzelnen freitragenden Schicht gebildeten Solarzelle. Dieser Vorteil wirkt sich noch stärker aus, wenn von dickeren, gesägten Substratscheiben ausgegangen wird. Bei Verwendung einer gesägten Substratscheibe von einer Dicke von z. B. 1 mm können mindestens 25 freitragende Schichten abgelöst werden. Pro freitragender Schicht ergibt sich dann ein Anteil von 4 % des Preises der gesägten Substratscheibe. Darüberhinaus haben die nach dem erfindungsgemäßen Verfahren hergestellten Solarzellen, wie oben schon ausgeführt, wegen ihrer geringeren Dicke und damit dem geringeren Bahnwiderstand einen verbesserten Wirkungsgrad.

Im folgenden wird die Erfindung anhand der Figuren und eines Ausführungsbeispiels genauer erläutert.
- Fig. 1: zeigt eine Substratscheibe mit einer Oberflächentopologie.
- Fig. 2: zeigt eine Draufsicht auf die in Fig. 1 dargestellte Substratscheibe.
- Fig. 3: und Fig. 4 zeigen das Ablösen einer freitragenden Schicht von der Substratscheibe.
- Fig. 5: bis Fig. 10 zeigen das Verfahren zur Herstellung der Solarzelle.

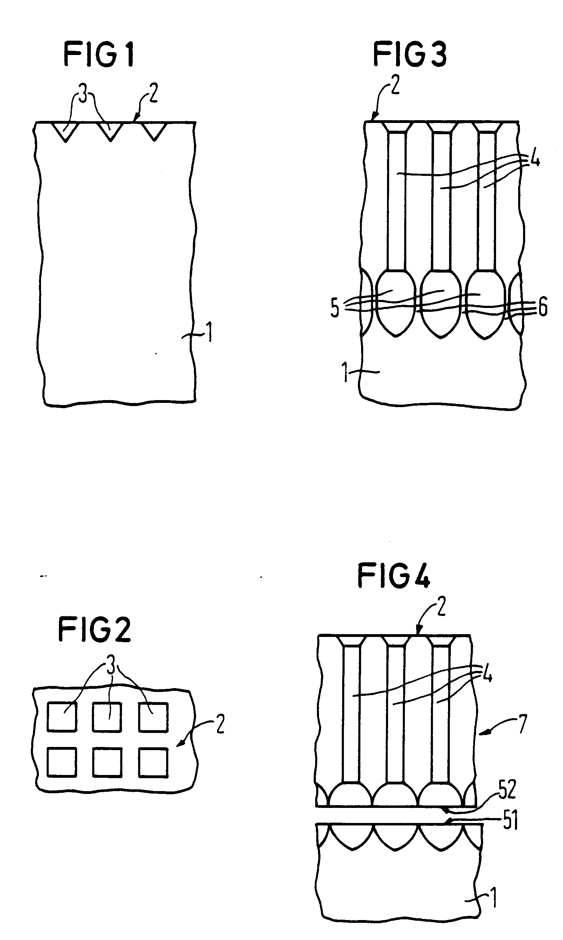

Eine Substratscheibe 1 aus n-dotiertem, einkristallinem Silizium mit z. B. 〈100〉-Orientierung ist in einer ersten Oberfläche 2 mit einer Vertiefung 3 umfassenden Oberflächentopologie versehen (s. Fig. 1). Die Substratscheibe 1 ist durch konventionelles Sägen in einer Dicke von z. B. 0,5 mm hergestellt. Die Vertiefungen 3 sind regelmäßig in der ersten Oberfläche 2 angeordnet (s. Draufsicht auf Fig. 1 in Fig. 2).

Die Vertiefungen 3 werden z. B. nach Herstellung einer Fotolackmaske mit Hilfe konventioneller Fotolithographie und anschließender alkalischer Ätzung hergestellt. Alternativ kann die Oberflächentopologie durch lichtinduzierte elektrochemische Ätzung gebildet werden.

Nach Herstellung der Vertiefungen 3 wird die erste Oberfläche 2 mit einem Elektrolyten in Kontakt gebracht. Der Elektrolyt ist fluoridhaltig und sauer. Er enthält eine Flußsäurekonzentration von 1 bis 50 %, vorzugsweise 6 %. Dem Elektrolyten kann ein Oxidationsmittel, z. B. Wasserstoffsuperoxyd, zugesetzt werden, um die Entwicklung von Wasserstoffbläschen auf der ersten Oberfläche 2 der Substratscheibe 1 zu unterdrücken. Zwischen die Substratscheibe 1 und den Elektrolyten wird eine Spannung von z. B. 3 Volt angelegt. Dabei wird die Substratscheibe 1, die z. B. eine Leitfähigkeit von 5 Ohm cm aufweist, als Anode verschaltet. Die Substratscheibe 1 wird von einer, der ersten Oberfläche 2 gegenüberliegenden zweiten Oberfläche her beleuchtet. Durch die Beleuchtung wird in der Substratscheibe 1 eine Stromdichte von 10 mA pro cm² eingestellt.

Mit diesen Prozeßparametern werden Löcher 4 in die erste Oberfläche 2 geätzt (s. Fig. 3). Die Löcher 4 verlaufen senkrecht Zur ersten Oberfläche 2. Sie weisen einen über ihre Tiefe konstanten Querschnitt parallel zur ersten Oberfläche 2 auf. Der Querschnitt der Löcher 4 ist abhängig von der Stromdichte in der Substratscheibe 1 und der Fluoridkonzentration des Elektrolyten.

Nach einer Ätzzeit von 60 Minuten wird mit den obengenannten Prozeßparametern eine Tiefe der Löcher 4 von etwa 30 µm erreicht. Bei dieser Tiefe wird die Stromdichte in der Substratscheibe 1 auf z. B. 30 mA pro cm² erhöht. Dabei wird die Spannung zwischen der Substratscheibe 1 und dem Elektrolyten auf 2 Volt eingestellt. Die Substratscheibe 1 wird weiterhin von der zweiten Oberfläche her beleuchtet. Durch diese veränderten Prozeßparameter entstehen am Boden der Löcher 4 höhlenförmige Erweiterungen 5, weil die Stromdichte vergrößert wurde. Benachbarte höhlenförmige Erweiterungen 5 werden durch Stege 6 getrennt. Die Breite der Stege 6 nimmt während der Ätzung ab. Nach etwa 10 Minuten sind mit den angegebenen Prozeßparametern die Stege 6 weggeätzt, und die höhlenförmigen Erweiterungen 5 und damit die Löcher 4 wachsen zusammen (s. Fig. 4). Dadurch wird eine freitragende Schicht 7 von dem Rest der Substratscheibe 1 abgelöst. Die freitragende Schicht 7 umfaßt die erste Oberfläche 2 und die Löcher 4. An der der ersten Oberfäche 2 abgewandten Seite weist die freitragende Schicht, bedingt durch das Zusammenwachsen der höhlenförmigen Erweiterungen 5 der Löcher 4 eine strukturierte Oberfläche 52 auf.

Der Rest der Substratscheibe 1 weist ebenfalls eine strukturierte Oberfläche 51, als Folge des Zusammenwachsens der höhlenförmigen Erweiterungen 5, auf. Die strukturierte Oberfläche 51 ist daher, bedingt durch ihre Entstehung, mit einer Oberflächentopologie versehen. Diese Oberflächentopologie entspricht der Anordnung der Vertiefungen 3 zu Beginn der Bearbeitung der Substratscheibe 1 (vgl. Fig. 1). Ausgehend von der Substratscheibe 1 mit der strukturierten Oberfläche 51 kann das Verfahren solange fortgesetzt werden, wie es die mechanische Stabilität des Restes der Substratscheibe erlaubt. Die Grenze liegt bei einer Dicke des Restes der Substratscheibe 1 von 100 bis 200 µm.

Die Dicke der freitragenden Schicht 7 ist durch die Tiefe der Löcher 4 festgelegt, da die Löcher 4 regelmäßig über die erste Oberfläche 2 verteilt sind. Diese regelmäßige Verteilung der Löcher 4 führt dazu, daß die Stege 6 im wesentlichen gleich breit sind und daher die höhlenförmigen Erweiterungen 5 im wesentlichen gleichzeitig zusammenwachsen. Das führt zu einer konstanten Dicke der freitragenden Schicht 7.

Da die strukturierte Oberfläche 51 des Restes der Substratscheibe 1 eine, den Vertiefungen 3 entsprechende Oberflächentopologie aufweist, ist die Dicke weiterer freitragender Schichten, die von dem Rest der Substratscheibe 1 abgelöst werden, bei gleichen Prozeßparametern immer dieselbe.

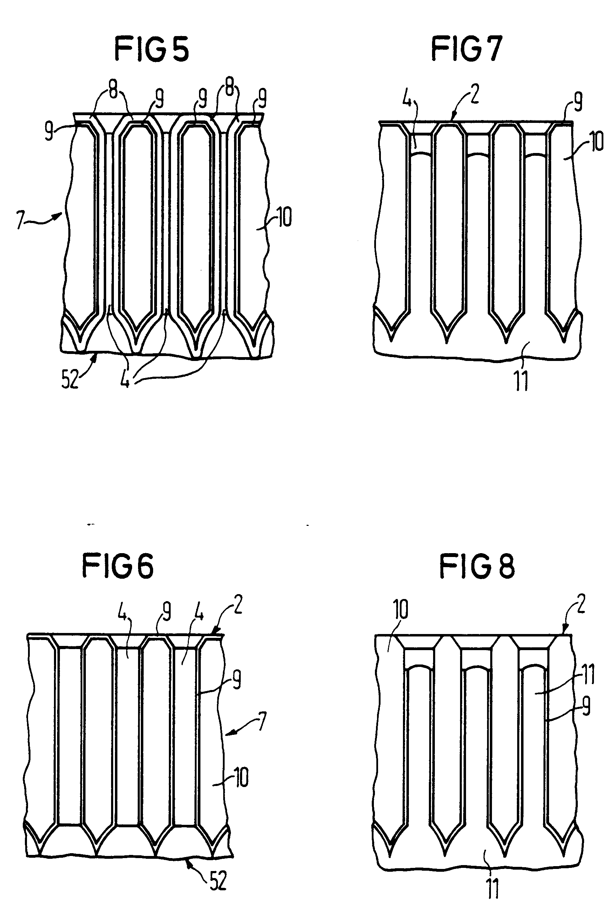

Aus der freitragenden Schicht 7 wird eine Solarzelle hergestellt. Dazu wird auf die gesamte Oberfläche der freitragenden Schicht 7 eine Schicht 8 aus Bor-Phosophor-Silikat-Glas (BPSG) aufgebracht. Die Schicht 8 bedeckt auch die Oberflächen der Löcher 4 (s. Fig. 5).

Durch Ausdiffusion von Bor aus der Schicht 8 aus BPSG wird ein p⁺-dotierter Bereich 9, der an der gesamten Oberfläche der freitragenden Schicht 7 angeordnet ist, gebildet. Die Dotierung in dem p⁺-dotiertem Bereich 9 wird auf z. B. 10¹⁹ pro cm³ eingestellt. Im Innern der freiliegenden Schicht 7 verbleibt ein n-dotierter Bereich 10.

Anschließend wird die Schicht 8 aus BPSG entfernt (s. Fig. 6) und eine Lackschicht 11 aufgetragen (s. Fig. 7). Die Lackschicht 11 wird so aufgebracht, daß sie die strukturierte Oberfläche 52 vollständig bedeckt, während im Bereich der ersten Oberfläche 2 und dem oberen, der ersten Oberfläche 2 benachbarten Teil der Löcher 4 der p⁺-dotierte Bereich 9 unbedeckt bleibt (s. Fig. 7).

Außerhalb der Lackschicht 11 wird in einem isotropen Ätzprozeß z. B. mit einem HF, HNO₃- Gemisch der freiliegenden Teil des p⁺-dotierten Bereiches 9 abgeätzt, so daß der n-dotierte Bereich 10 an der ersten Oberfläche 2 und dem oberen Teil der Löcher 4 freigelegt wird (s. Fig. 8).

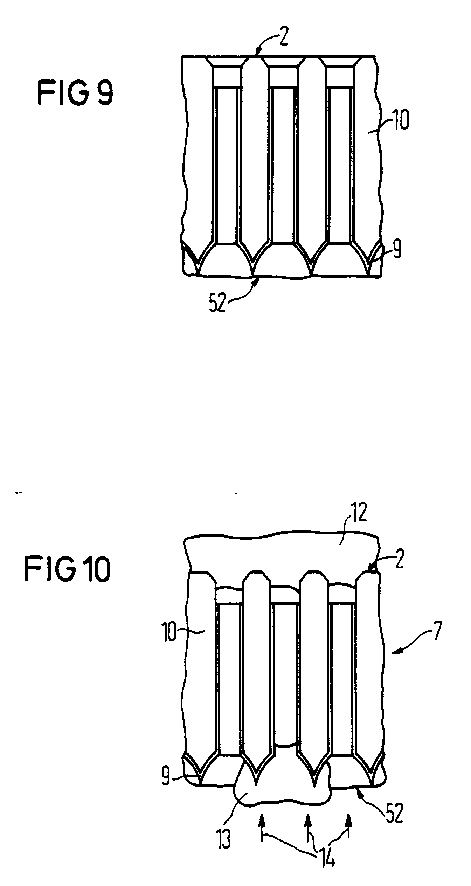

Nach Entfernung der Lackschicht 11 (s. Fig. 9) wird ein den n-dotierten Bereich 10 kontaktierender erster Kontakt 12 und ein den p⁺-dotierten Bereich 9 kontaktierender zweiter Kontakt 13 hergestellt (s. Fig. 10). Der erste Kontakt 12 und der zweite Kontakt 13 sind ohm'sche Kontakte, die z. B. mittels einer Silberleitpaste definiert werden.

Der erste Kontakt 12 zum Anschluß des n-dotierten Bereiches 10 wird als durchgehender Kontakt auf die erste Oberfläche 2 aufgebracht. Der zweite Kontakt 13 wird in strukturierter Form auf die strukturierte Oberfläche 52 aufgebracht. Der zweite Kontakt 13 ist dabei so strukturiert, daß der Lichteinfall, angedeutet durch Pfeile 14, von der strukturierten Oberfläche 52 her in die freitragende Schicht 7 erfolgt. Zur Verbesserung der Leitfähigkeit kann unter den ersten Kontakt 12 und den zweiten Kontakt 13 eine leitfähige Schicht aus z. B. Indium-Zinn-Oxid (ITO) aufgebracht werden.

Die strukturierte Oberfläche 52, durch die der Lichteinfall in die fertige Solarzelle erfolgt, entsteht in dem erfindungsgemäßen Verfahren beim Ablösen der freitragenden Schicht 7. Diese strukturierte Oberfläche 52 weist eine sehr geringe Lichtreflexion auf, was für die Solarzelle ein weiterer Vorteil ist.

Der Wirkungsgrad der Solarzelle kann noch weiter verbessert werden durch eine Oberflächenpassivierung durch Aufbringen einer Schicht aus thermischem SiO₂ nach dem Entfernen der Schicht 8 aus BPSG. Darüberhinaus läßt sich der Wirkungsgrad dadurch verbessern, daß nach dem Freilegen des n-dotierten Bereichs 10 durch Abätzen des p⁺-dotierten Bereichs 9 und vor dem Entfernen der Lackschicht 11 die freigelegten Teile des n-dotierten Bereichs 10 durch Diffusion oder Implantation mit einer höheren n⁺-Dotierung versehen werden. Es empfiehlt sich z. B. eine Dotierstoffkonzentration von 10¹⁹ pro cm⁻³. .

## Patentansprüche

1. Verfahren zur Herstellung einer Solarzelle aus einer Substratscheibe,
- bei dem von einer Substratscheibe (1) aus n-dotiertem, einkristallinem Silizium durch elektrochemisches Ätzen eine freitragende Schicht (7) aus n-dotiertem, einkristallinem Silizium dadurch abgelöst wird,
- daß in einer ersten Oberfläche (2) der Substratscheibe (1) durch elektrochemisches Ätzen Löcher (4) gebildet werden,
- daß bei Erreichen einer Tiefe der Löcher (4), die im wesentlichen der Dicke der zu bilden den freitragenden Schicht (7) entspricht, die Prozeßparameter der Ätzung so geändert werden, daß an Bolden der Löcher der Querschnitt der Löcher (4) wächst und daß die freitragende Schicht durch Zusammenwachsen der Löcher (4, 5) abgelöst wird,
- bei dem in der freitragenden Schicht (7) mindestens ein p-n-Übergang (9, 10) hergestellt wird,
- bei dem die freitragende Schicht (7) so mit Kontakten (12, 13) versehen wird, daß der p-n-Übergang (9, 10) eine Solarzelle bildet.

2. Verfahren nach Anspruch 1,
bei dem die elektrochemische Ätzung in einem fluoridhaltigen, sauren Elektrolyten durchgeführt wird, mit dem die erste Oberfläche in Kontakt steht und zwischen den und Substratscheibe (1) eine elektrische Spannung so angelegt wird, daß die Substratscheibe (1) als Anode verschaltet ist und daß in der Substratscheibe eine den Ätzabtrag beeinflussende Stromdichte eingestellt wird.

3. Verfahren nach Anspruch 1 oder 2,
bei dem die Löcher (4) senkrecht zur ersten Oberfläche (2) gebildet werden.

4. Verfahren nach einem der Ansprüche 1 bis 3,
bei dem die Substratscheibe eine <100> -Scheibe ist.

5. Verfahren nach einem der Ansprüche 1 bis 4,
bei dem die Substratscheibe (1) durch eine der ersten Oberfläche (2) gegenüberliegende, zweite Oberfläche beleuchtet wird, um die Stromdichte in der Substratscheibe (1) einzustellen.

6. Verfahren nach einem der Ansprüche 1 bis 5,
bei dem an der ersten Oberfläche (2) der Substratscheibe (1) vor der Bildung der Löcher (4) eine Oberflächentopologie erzeugt wird, die die Anodnung der Löcher (4) bestimmt.

7. Verfahren nach Anspruch 6,
bei dem die Oberflächentopologie aus regelmäßig angeordneten Vertiefungen (3) der Oberfläche besteht.

8. Verfahren nach Anspruch 6 oder 7,
bei dem die Oberflächentopologie durch Herstellung einer Fotolackmaske auf der ersten Oberfläche (2) der Substratscheibe (1) und anschließende alkalische Ätzung der ersten Oberfläche (2) der Substratscheibe (1) erzeugt wird.

9. Verfahren nach Anspruch 6 oder 7,
bei dem die Oberflächentopologie durch elektrochemisches Ätzen in dem Elektrolyten dadurch erzeugt wird, daß auf der ersten Oberfläche (2) unter Verwendung einer Lichtquelle mit einer Wellenlänge kleiner als 1100 nm ein Beleuchtungsmuster erzeugt wird und daß die Stromdichte in der Substratscheibe (1) so eingestellt wird, daß nur an belichteten Stellen des Beleuchtungsmusters lokal ein anodischer Minoritätsträgerstrom über die Substratscheibe (1) fließt, der einen Ätzabtrag der ersten Oberfläche (2) bewirkt.

10. Verfahren nach einem der Ansprüche 1 bis 9,
bei dem der Elektrolyt 1 bis 50 % Flußsäure (HF) enthält.

11. Verfahren nach Anspruch 10,
bei dem der Elektrolyt zusätzlich ein Oxidationsmittel enthält.

12. Verfahren nach einem der Ansprüche 1 bis 11,
bei dem zum Ablösen der freitragenden Schicht (7) die Stromdichte in der Substratscheibe (1) erhöht wird.

13. Verfahren nach einem der Ansprüche 2 bis 11,
bei dem zum Ablösen der freitragenden Schicht (7) die Konzentration des Fluorid im Elektrolyten reduziert wird.

14. Verfahren nach einem der Ansprüche 1 bis 13,
- bei dem nach dem Ablösen der freitragenden Schicht (7) mindestens eine weitere freitragende Schicht von der Substratscheibe (1) durch elektrochemisches Ätzen abgelöst wird,
- bei dem in der weiteren freitragenden Schicht (7) mindestens ein pn-Übergang (9, 10) hergestellt wird,
- bei dem die weitere freitragende Schicht so mit Kontakten versehen wird, daß der pn-Übergang als Solarzelle verschaltbar ist.

15. Verfahren nach einem der Ansprüche 1 bis 14,
bei dem der pn-Übergang (9, 10) in der freitragenden Schicht (7) dadurch hergestellt wird, daß die freitragende Schicht (7) mit einer Schicht (8) aus Bor-Phosphor-Silikat-Glas überzogen wird und daß durch Ausdiffusion von Bor aus der Schicht aus Bor-Phosophor-Silikat-Glas in der freitragenden Schicht ein p⁺-dotierter Bereich (9) erzeugt wird.

16. Verfahren nach Anspruch 15,
bei dem die Schicht (8) aus Bor-Phosphor-Silikat-Glas die gesamte Oberfläche der freitragenden Schicht (7) bedeckt und der p⁺-dotierte Bereich (9) die gesamte Oberfläche der freitragenden Schicht (7) bedeckt, während die freitragende Schicht (7) im Inneren einen n-dotierten Bereich (10) umfaßt.

17. Verfahren nach Anspruch 16,
- bei dem nach Entfernen der Schicht (8) aus Bor-Phosphor-Silikat-Glas die freitragende Schicht (7) mit einer Lackschicht (11) versehen wird, die bis auf die erste Oberfläche (2) der freitragenden Schicht (7) und den oberen Teil der Löcher (4) im Bereich der ersten Oberfläche (2) alle Oberflächen des p⁺-dotierten Bereichs abdeckt,
- bei dem die von der Lackschicht (11) unbedeckten Teile des p⁺-dotierten Bereichs (9) selektiv zur Lackschicht (11) abgeätzt werden, so daß an der ersten Oberfläche (2) der n-dotierte Bereich (10) freigelegt wird.

18. Verfahren nach Anspruch 17,
bei dem vor dem Aufbringen der Lackschicht (11) die Oberfläche des p⁺-dotierten Bereichs (9) mit einer Passivierungsschicht aus thermischen SiO₂ versehen wird.

19. Verfahren nach Anspruch 17 oder 18,
bei dem im Bereich der ersten Oberfläche (2) die freigelegten Teile des n-dotierten Bereichs (10) mit einer n⁺-Dotierung versehen werden.

20. Verfahren nach einem der Ansprüche 17 bis 19,
bei dem nach Entfernen der Lackschicht auf die erste Oberfläche (2) mindestens ein Kontakt zum Anschluß des n-dotierten Bereichs (10) und auf die der ersten Oberfläche gegenüberliegende, strukturierte Oberfläche (52) mindestens ein Kontakt (13) zum Anschluß des p⁺-dotierten Bereichs (9) so aufgebracht wird, daß Licht durch die strukturierte Oberfläche (52) in die freitragende Schicht (7) eingestrahlt werden kann.

## Claims

1. Method for producing a solar cell from a substrate wafer,
- in which a self-supporting layer (7) of n-doped, monocrystalline silicon is detached from a substrate wafer (1) of n-doped, monocrystalline silicon by electrochemical etching,
- in that holes (4) are formed in a first surface (2) of the substrate wafer (1) by electrochemical etching,
- and in that, when a depth of the holes (4) which essentially corresponds to the thickness of the self-supporting layer (7) to be formed is reached, the process parameters of the etching are modified such that the cross-section of the holes (4) increases at the bottom of the holes and such that the self-supporting layer is detached as a result of the holes (4, 5) growing together,
- in which at least one p-n junction (9, 10) is produced in the self-supporting layer (7),
- and in which the self-supporting layer (7) is provided with contacts (12, 13) such that the p-n junction (9, 10) forms a solar cell.

2. Method according to Claim 1, in which the electrochemical etching is carried out in a fluoride-containing acidic electrolyte with which the first surface is in contact and between which and the substrate wafer (1) an electrical voltage is applied such that the substrate wafer (1) is connected as the anode and such that a current density which influences the etching erosion is set up in the substrate wafer.

3. Method according to Claim 1 or 2, in which the holes (4) are formed perpendicularly to the first surface (2).

4. Method according to one of Claims 1 to 3, in which the substrate wafer is a <100>-oriented wafer.

5. Method according to one of Claims 1 to 4, in which the substrate wafer (1) is illuminated through a second surface, lying opposite the first surface (2), in order to set up the current density in the substrate wafer (1),

6. Method according to one of Claims 1 to 5, in which a surface topology which determines the arrangement of the holes (4) is produced on the first surface (2) of the substrate wafer (1) before formation of the holes (4).

7. Method according to Claim 6, in which the surface topology comprises regularly arranged depressions (3) in the surface.

8. Method according to Claim 6 or 7, in which the surface topology is produced by forming a photoresist mask on the first surface (2) of the substrate wafer (1) and subsequent alkaline etching of the first surface (2) of the substrate wafer (1).

9. Method according to Claim 6 or 7, in which the surface topology is produced by electrochemical etching in the electrolyte in that an illumination pattern is produced on the first surface (2) by using a light source having a wavelength of less than 1100 nm and in that the current density in the substrate wafer (1) is set up such that an anodic minority-carrier current which causes etching erosion of the first surface (2) locally flows over the substrate wafer (1) only at illuminated points on the illumination pattern.

10. Method according to one of Claims 1 to 9, in which the electrolyte contains 1 to 50 % of hydrofluoric acid (HF).

11. Method according to Claim 10, in which the electrolyte additionally contains an oxidizing agent.

12. Method according to one of Claims 1 to 11, in which the current density in the substrate wafer (1) is increased in order to detach the self-supporting layer (7).

13. Method according to one of Claims 2 to 11, in which the concentration of the fluoride in the electrolyte is reduced in order to detach the self-supporting layer (7).

14. Method according to one of Claims 1 to 13,
- in which, after detachment of the self-supporting layer (7), at least one other self-supporting layer is detached from the substrate wafer (1) by electrochemical etching,
- in which at least one p-n junction (9, 10) is produced in the other self-supporting layer (7),
- and in which the other self-supporting layer is provided with contacts such that the p-n junction can be connected as a solar cell.

15. Method according to one of Claims 1 to 14, in which the p-n junction (9, 10) is produced in the self-supporting layer (7) in that the self-supporting layer (7) is coated with a layer (8) of boro-phosphorus silicate glass and in that a p⁺-doped region (9) is produced in the self-supporting layer by diffusing out boron from the layer of boro-phosphorus silicate glass.

16. Method according to Claim 15, in which the layer (8) of boro-phosphorus silicate glass covers the entire surface of the self-supporting layer (7) and the p⁺-doped region (9) covers the entire surface of the self-supporting layer (7), whereas the self-supporting layer (7) internally comprises an n-doped region (10).

17. Method according to Claim 16,
- in which, after removal of the layer (8) of borophosphorus silicate glass, the self-supporting layer (7) is provided with a resist layer (11) which covers all surfaces of the p⁺-doped region as far as the first surface (2) of the self-supporting layer (7) and the upper part of the holes (4) in the region of the first surface (2),
- and in which the parts of the p⁺-doped region (9) not covered by the resist layer (11) are etched selectively with respect to the resist layer (11) so that the n-doped region (10) is uncovered on the first surface (2).

18. Method according to Claim 17, in which the surface of the p⁺-doped region (9) is provided with a passivation layer of thermal SiO₂ before application of the resist layer (11).

19. Method according to Claim 17 or 18, in which the uncovered parts of the n-doped region (10) are provided with an n⁺-doping in the region of the first surface (2).

20. Method according to one of Claims 17 to 19, in which, after removal of the resist layer, at least one contact for connecting the n-doped region (10) is applied onto the first surface (2) and at least one contact (13) for connecting the p⁺-doped region (9) is applied onto the structured surface (52) lying opposite the first surface, such that light can be radiated into the self-supporting layer (7) through the structured surface (52).

## Revendications

1. Procédé de fabrication d'une cellule solaire à partir d'un substrat, selon lequel
- on sépare d'un substrat (1) en silicium monocristallin de type n-dopé par attaque électrochimique, une couche saillante (7) en silicium monocristallin de type n-dopé et
- dans une première surface (2) du substrat (1), on forme des trous (4) par attaque électrochimique,
- en atteignant une certaine profondeur des trous (4), qui correspond pour l'essentiel à l'épaisseur de la couche saillante (7) en formation, les paramètres de procédé de l'attaque sont modifiés au point qu'au fond des trous, la section des trous (4) augmente et que la couche saillante est séparée par des trous (4, 5) qui se rejoignent en croissant,
- on établit au moins une jonction p-n (9, 10) dans la couche saillante (7),
- la couche saillante (7) est dotée de contacts (12, 13) de sorte que la jonction p-n (9, 10) forme une cellule solaire.

2. Procédé selon la revendication 1 selon lequel l'attaque électrochimique est effectuée dans un électrolyte acide contenant du fluorure avec lequel la première surface est en contact, et pour lequel on applique entre celui-ci et le substrat (1), une tension électrique de façon à ce que le substrat (1) soit connecté en tant qu'anode, et à ce que dans le substrat il soit établi une densité de courant influençant l'enlèvement par attaque.

3. Procédé selon la revendication 1 ou 2 selon lequel les trous (4) sont formés perpendiculairement à la première surface (2).

4. Procédé selon l'une des revendications 1 à 3, selon lequel le substrat est une couche <100>.

5. Procédé selon l'une des revendications 1 à 4, selon lequel le substrat (1) est éclairé par une deuxième surface opposée à la première surface (2) afin de régler la densité de courant dans le substrat (1).

6. Procédé selon l'une des revendications 1 à 5, selon lequel on produit sur la première surface (2) du substrat (1) avant la formation des trous (4), une topologie de surface, qui détermine la disposition des trous (4).

7. Procédé selon la revendication 6, selon lequel la topologie de surface est composée d'empreintes de suface (3) régulièrement d:sposées.

8. Procédé selon la revendication 6 ou 7, selon lequel la topologie de surface est produite par fabrication d'un masque de laque photosensible sur la première suface (2) du substrat (1) et par l'attaque alcaline consécutive de la première surface (2) du substrat (1).

9. Procédé selon la revendication 6 ou 7 selon lequel la topologie de surface est réalisée par attaque électrochimique dans l'électrolyte par le fait que sur la première surface (2) on produit un dessin d'éclairage en utilisant une source lumineuse dont la longueur d'onde est inférieure à 1100 nm et par le fait que la densité de courant dans le substrat (1) est réglée de sorte qu'un courant anodique de porteur minoritaire ne passe que lcoalement aux points éclairés du dessin d'éclairage sur le substrat (1) qui entraîne un enlèvement par attaque de la première couche (2).

10. Procédé selon l'une des revendications 6 à 9, selon lequel l'électrolyte contient de 1 à 50% d'acide fluorhydrique (HF).

11. Procédé selon la revendication 10, selon lequel l'électrolyte contient en plus un oxydant.

12. Procédé selon l'une des revendications 1 à 11, selon lequel la séparation de la couche saillante (7) est effectuée par augmentation de la densité de courant dans le substrat (1).

13. Procédé selon l'une des revendications 2 à 11, selon lequel la séparation de la couche saillante (7) est effectuée par réduction de la concentration du fluorure dans l'électrolyte.

14. Procédé selon l'une des revendications 1 à 13, selon lequel après la séparation de la couche saillante (7), on sépare au moins une autre couche saillante du substrat (1) par attaque électrochimique,
- on produit au moins une jonction p-n (9-10) dans l'autre couche saillante (7),
- l'autre couche saillante est dotée de contacts de sorte que la jonction pn est connectable en tant que cellule solaire.

15. Procédé selon l'une des revendications 1 à 14, selon lequel la jonction pn (9,10) est réalisée dans la couche saillante (7) par le fait que la couche saillante (7) est revêtue d'une couche (8) en bore-phosphore-silicate-verre et par le fait que l'on produit une zone dopée de type p⁺ (9) dans la couche saillante par diffusion du bore de la couche en bore-phosphoresilicate-verre.

16. Procédé selon la revendication 15, selon lequel la couche (8) en bore-phosphore-silicate-verre recouvre toute la surface de la couche saillante (7) et la zone dopée de type p⁺ (9) recouvre toute la surface de la couche saillante (7) alors que la couche saillante (7) comprend à l'intérieur une zone dopée de type n (10).

17. Procédé selon la revendication 16, selon lequel
- après enlèvement de la couche (8) en bore-phosphore-silicate-verre, la couche saillante (7) est dotée d'une couche de laque (11) qui recouvre toutes les surfaces de la zone dopée de type p⁺ à l'exception de la première surface (2) de la couche saillante (7) et de la partie supérieure des trous (4) dans la zone de la première surface (2),
- les parties non recouvertes par la couche de laque (11) de la zone dopée de type p⁺ (9) sont attaquées sélectivement eu égard à la couche de laque (11) de manière à libérer la zone dopée de type n (10) sur la première surface (2).

18. Procédé selon la revendication 17, selon lequel la surface de la zone dopée de type p⁺ (9) est dotée d'une couche de passivation en SiO₂ thermique avant application de la couche de laque (11).

19. Procédé selon la revendication 17 ou 18, selon lequel les parties libérées de la zone dopée de type n (10) sont munies d'un dopage de type n+ dans la zone de la première surface (2).

20. Procédé selon l'une des revendications 17 à 19, selon lequel après enlèvement de la couche de laque, on applique sur la première surface (2) au moins un contact pour raccordement de la zone dopée de type n (10) et sur la surface structurée (52) opposée à la première surface, au moins un contact (13) pour raccordement de la zone dopée de type p⁺ (9) de façon à ce que la lumière puisse être projetée à travers la surface structurée (52) dans la couche saillante (7).
